# EUROPEAN PATENT APPLICATION

(11) **EP 4 848 012 A1**
(43) Date of publication of application: **02.12.2026**
(21) Application number: 26157090.7
(22) Date of filing: 06.02.2026
(51) Int. Cl.: G05B 19/042, B64D 27/33, G01R 31/00, H02M 1/36

(54) **POWER CONVERTER DIAGNOSTIC SYSTEM AND METHOD**

(30) Priority: 28.05.2025 US 202519220845
(71) Applicant: General Electric Company, Cincinnati, Ohio 45215 (US)
(72) Inventor: FREELY, Brendan Michael, Evendale, 45241 (US); GEMIN, Paul Robert, Evendale, 45241 (US); SHAFFER, Benjamin, Evendale, 45241 (US)
(74) Representative: Openshaw & Co.

(57) **Abstract**

A diagnostic system for an aeronautical power system includes a power converter electrically connected to an electrical system of an aircraft. A power supply is connected to the power converter where electrical energy is received via an input line to power subsystems of the power converter. A controller is electrically connected to the power converter and one or more sensors. The controller is configured to monitor, during a start-up sequence of the one or more subsystems, a current flowing through the input line via the one or more sensors during at least a portion of the start-up sequence. The controller is configured to analyze the current to determine a health status of at least one subsystem of the one or more subsystems and, in response to identifying a current anomaly affecting the health status of the at least one subsystem, output an indication of the health status.

## Description

### FEDERALLY SPONSORED RESEARCH

This invention was made with government support under contract number 80AFRC-21-C-A021 awarded by the National Aeronautics and Space Administration. The U.S. government may have certain rights in the invention.

### FIELD

The present disclosure relates to a power converter health diagnostic system and method.

### BACKGROUND

A conventional commercial aircraft generally includes a fuselage, a pair of wings, and a propulsion system that provides thrust. The propulsion system typically includes at least two aircraft engines, such as turbofan jet engines. Each turbofan jet engine is typically mounted to a respective one of the wings of the aircraft, such as in a suspended position beneath the wing separated from the wing and fuselage.

Hybrid-electric propulsion systems are being developed to improve the efficiency of conventional commercial aircraft. Some hybrid electric propulsion systems include one or more electric machines each being mechanically coupled with a rotating component of one of the aircraft engines. The electric machines can each have an associated power electronics assembly electrically connected thereto including a power converter and power distribution or management units.

### BRIEF DESCRIPTION OF THE DRAWINGS

A full and enabling disclosure of the present disclosure, including the best mode thereof, directed to one of ordinary skill in the art, is set forth in the specification, which makes reference to the appended figures, in which:
FIG. 1 provides a schematic top view of an aircraft having a hybrid-electric propulsion system according to various exemplary embodiments of the present disclosure.
FIG. 2 provides a schematic cross-sectional view of one of the hybrid-electric-capable propulsors of the aircraft of FIG. 1.
FIG. 3 is a simplified, schematic view of an electrical system for an aeronautical power system in accordance with an exemplary aspect of the present disclosure.
FIG. 4 is a block diagram view of a diagnostic system for a power converter for an aeronautical power system in accordance with an exemplary aspect of the present disclosure.
FIG. 5 is a block diagram view of a diagnostic system for a power converter for an aeronautical power system in accordance with an exemplary aspect of the present disclosure.
FIG. 6 depicts a graphical illustration of electrical responses or current transients measured by a diagnostic system for a power converter for an aeronautical power system in accordance with an exemplary aspect of the present disclosure.
FIG. 7 provides an example computing system according to exemplary embodiments of the present disclosure.
FIG. 8 is a flow diagram depicting a method for diagnostic evaluation of a power converter of an aeronautical power system in accordance with an exemplary aspect of the present disclosure.

### DETAILED DESCRIPTION

Reference will now be made in detail to present embodiments of the disclosure, one or more examples of which are illustrated in the accompanying drawings. The detailed description uses numerical and letter designations to refer to features in the drawings. Like or similar designations in the drawings and description have been used to refer to like or similar parts of the disclosure.

The word "exemplary" is used herein to mean "serving as an example, instance, or illustration." Any implementation described herein as "exemplary" is not necessarily to be construed as preferred or advantageous over other implementations. Additionally, unless specifically identified otherwise, all embodiments described herein should be considered exemplary.

The singular forms "a", "an", and "the" include plural references unless the context clearly dictates otherwise.

The term "at least one of" in the context of, e.g., "at least one of A, B, and C" refers to only A, only B, only C, or any combination of A, B, and C.

As used herein, the terms "first", "second", and "third" may be used interchangeably to distinguish one component from another and are not intended to signify location or importance of the individual components.

The term "turbomachine" refers to a machine including one or more compressors, a heat generating section (e.g., a combustion section), and one or more turbines that together generate a torque output.

The term "gas turbine engine" refers to an engine having a turbomachine as all or a portion of its power source. Example gas turbine engines include turbofan engines, turboprop engines, turbojet engines, turboshaft engines, etc., as well as hybrid-electric versions of one or more of these engines.

The term "combustion section" refers to any heat addition system for a turbomachine. For example, the term combustion section may refer to a section including one or more of a deflagrative combustion assembly, a rotating detonation combustion assembly, a pulse detonation combustion assembly, or other appropriate heat addition assembly. In certain example embodiments, the combustion section may include an annular combustor, a can combustor, a cannular combustor, a trapped vortex combustor (TVC), or other appropriate combustion system, or combinations thereof.

The terms "low" and "high", or their respective comparative degrees (e.g., -er, where applicable), when used with a compressor, a turbine, a shaft, or spool components, etc. each refer to relative speeds within an engine unless otherwise specified. For example, a "low turbine" or "low speed turbine" defines a component configured to operate at a rotational speed, such as a maximum allowable rotational speed, lower than a "high turbine" or "high speed turbine" of the engine.

The terms "forward" and "aft" refer to relative positions within a gas turbine engine or vehicle, and refer to the normal operational attitude of the gas turbine engine or vehicle. For example, with regard to a gas turbine engine, forward refers to a position closer to an engine inlet and aft refers to a position closer to an engine nozzle or exhaust.

The terms "upstream" and "downstream" refer to the relative direction with respect to a flow in a pathway. For example, with respect to a fluid flow, "upstream" refers to the direction from which the fluid flows, and "downstream" refers to the direction to which the fluid flows. However, the terms "upstream" and "downstream" as used herein may also refer to a flow of electricity.

As used herein, the terms "axial" and "axially" refer to directions and orientations that extend substantially parallel to a centerline of the gas turbine engine. Moreover, the terms "radial" and "radially" refer to directions and orientations that extend substantially perpendicular to the centerline of the gas turbine engine. In addition, as used herein, the terms "circumferential" and "circumferentially" refer to directions and orientations that extend arcuately about the centerline of the gas turbine engine.

A "third stream" as used herein means a non-primary air stream capable of increasing fluid energy to produce a minority of total propulsion system thrust. The third stream may generally receive inlet air (air from a ducted passage downstream of a primary fan) instead of freestream air (as the primary fan would). A pressure ratio of the third stream may be higher than that of the primary propulsion stream (e.g., a bypass or propeller driven propulsion stream). The thrust may be produced through a dedicated nozzle or through mixing of an airflow through the third stream with a primary propulsion stream or a core air stream, e.g., into a common nozzle.

In certain exemplary embodiments, an operating temperature of the airflow through the third stream may be less than a maximum compressor discharge temperature for the engine, and, more specifically may be less than 350 degrees Fahrenheit (such as less than 300 degrees Fahrenheit, such as less than 250 degrees Fahrenheit, such as less than 200 degrees Fahrenheit, and at least as great as an ambient temperature). In certain exemplary embodiments, these operating temperatures may facilitate heat transfer to or from the airflow through the third stream and a separate fluid stream. Further, in certain exemplary embodiments, the airflow through the third stream may contribute less than 50% of the total engine thrust (and at least, e.g., 2% of the total engine thrust) at a takeoff condition, or more particularly while operating at a rated takeoff power at sea level, static flight speed, 86 degree Fahrenheit ambient temperature operating conditions.

Furthermore, in certain exemplary embodiments, aspects of the airflow through the third stream (e.g., airstream, mixing, or exhaust properties), and thereby the aforementioned exemplary percent contribution to total thrust, may passively adjust during engine operation or be modified purposefully through use of engine control features (such as fuel flow, electric machine power, variable stators, variable inlet guide vanes, valves, variable exhaust geometry, or fluidic features) to adjust or optimize overall system performance across a broad range of potential operating conditions.

The terms "coupled," "fixed," "attached to," and the like refer to both direct coupling, fixing, or attaching, as well as indirect coupling, fixing, or attaching through one or more intermediate components or features, unless otherwise specified herein.

As used herein, the terms "first", "second", and "third" may be used interchangeably to distinguish one component from another and are not intended to signify location or importance of the individual components.

Embodiments of the present disclosure include a health diagnostic system and method for a power converter. A power converter may include one or more subsystems that are used by the power converter to provide a power conversion function. Embodiments of the present disclosure diagnose power converter health and detect trends that indicate degradation of certain components or subsystems of the power converter. Power converters may be supplied with a general low-voltage power supply to power internal circuitry and/or subsystems such as, by way of non-limiting example, low-power components such as fans, and to provide a source for housekeeping voltages that the power converter uses to run various internal power supplies or subsystems. The power draw from the low-voltage supply may be dependent on an operating condition of the power converter but can also change over time based on component health such as power stage gate driver power consumption, fan power supply, and contactor power supply. Variations in these from known baselines, or trends over time, can be used to identify leading indications of failing components or necessary upcoming maintenance.

In exemplary embodiments, the power draw from the low-voltage supply can be monitored in conjunction with a power-on built-in test (PBIT)-type start-up sequence of the various subsystems of the power converter. During the startup sequence, the one or more subsystems of the power converter are enabled and/or tested such that the power draw from the low-voltage supply can be correlated to a particular subsystem. During such a start-up sequence, current draw can provide: an initial baseline for the upcoming flight of the aircraft, an early indication of subsystem failure or impending failure if measured current draw is significantly off-trend, and potentially the subsystem of the suspect component. During a run mode of the power converter (e.g., upon completion of any PBIT operations) in-flight monitoring of current draw from the low-voltage power supply compared to known trends with power converter operating points can provide trending data over time to provide advanced notice of impending weakened components.

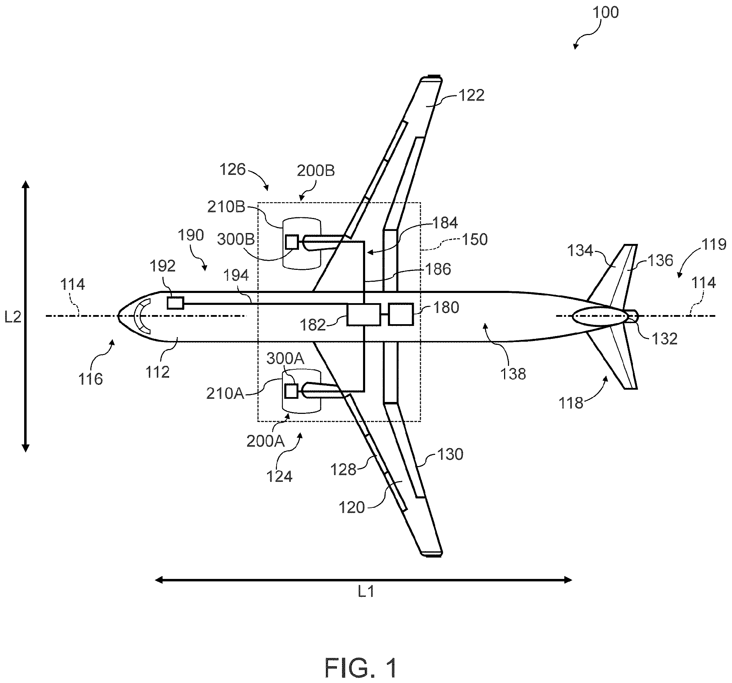

Referring now to the drawings, wherein identical numerals indicate the same elements throughout the figures, FIG. 1 provides a schematic top view of an exemplary aircraft 100 as may incorporate one or more inventive aspects of the present disclosure. As shown in FIG. 1, for reference, the aircraft 100 defines a longitudinal direction L1 and a lateral direction L2. The lateral direction L2 is perpendicular to the longitudinal direction L1. The aircraft 100 also defines a longitudinal centerline 114 that extends therethrough along the longitudinal direction L1. The aircraft 100 extends between a forward end 116 and an aft end 118, e.g., along the longitudinal direction L1.

As depicted, the aircraft 100 includes a fuselage 112 that extends longitudinally from the forward end 116 of the aircraft 100 to the aft end 118 of the aircraft 100. The aircraft 100 also includes an empennage 119 at the aft end 118 of the aircraft 100. In addition, the aircraft 100 includes a wing assembly including a first, port side wing 120 and a second, starboard side wing 122. The first and second wings 120, 122 each extend laterally outward with respect to the longitudinal centerline 114. The first wing 120 and a portion of the fuselage 112 together define a first side 124 of the aircraft 100 and the second wing 122 and another portion of the fuselage 112 together define a second side 126 of the aircraft 100. For the embodiment depicted, the first side 124 of the aircraft 100 is configured as the port side of the aircraft 100 and the second side 126 of the aircraft 100 is configured as the starboard side of the aircraft 100.

The aircraft 100 includes various control surfaces. For this embodiment, each wing 120, 122 includes one or more leading edge flaps 128 and one or more trailing edge flaps 130. The aircraft 100 further includes, or more specifically, the empennage 119 of the aircraft 100 includes a vertical stabilizer 132 having a rudder flap (not shown) for yaw control and a pair of horizontal stabilizers 134 each having an elevator flap 136 for pitch control. The fuselage 112 additionally includes an outer surface or skin 138. It should be appreciated that in other exemplary embodiments of the present disclosure, the aircraft 100 may additionally or alternatively include any other suitable configuration. For example, in other embodiments, the aircraft 100 may include any other control surface configuration.

The exemplary aircraft 100 of FIG. 1 also includes a hybrid-electric propulsion system 150. For this embodiment, the hybrid-electric propulsion system 150 has a first propulsor 200A and a second propulsor 200B both operable to produce thrust. The first propulsor 200A is mounted to the first wing 120 and the second propulsor 200B is mounted to the second wing 122. Moreover, for the embodiment depicted, the first propulsor 200A and second propulsor 200B are each configured in an underwing-mounted configuration. However, in other example embodiments, one or both of the first and second propulsors 200A, 200B may be mounted at any other suitable location in other exemplary embodiments.

The first propulsor 200A includes a gas turbine engine 210A and one or more electric machines, such as electric machine 300A mechanically coupled with the gas turbine engine 210A. The electric machine 300A can be an electric generator, an electric motor, or a combination generator/motor. For this example embodiment, the electric machine 300A is a combination generator/motor. In this manner, when operating as an electric generator, the electric machine 300A can generate electrical power when driven by the gas turbine engine 210A. When operating as an electric motor, the electric machine 300A can drive or motor the gas turbine engine 210A.

Likewise, the second propulsor 200B includes a gas turbine engine 210B and one or more electric machines, such as electric machine 300B mechanically coupled with the gas turbine engine 210B. The electric machine 300B can be an electric generator, an electric motor, or a combination generator/motor. For this example embodiment, the electric machine 300B is a combination generator/motor. In this manner, when operating as an electric generator, the electric machine 300B can generate electrical power when driven by the gas turbine engine 210B. When operating as an electric motor, the electric machine 300B can drive or motor a spool of the gas turbine engine 210B. Electric machine 300B can be configured and can operate in a similar manner as electric machine 300A described herein.

The hybrid-electric propulsion system 150 further includes an electric energy storage unit 180 electrically connectable to the electric machines 300A, 300B, and in some embodiments, other electrical loads. In some exemplary embodiments, the electric energy storage unit 180 may include one or more batteries. Additionally, or alternatively, the electric energy storage units 180 may include one or more supercapacitor arrays, one or more ultracapacitor arrays, or both. For the hybrid-electric propulsion system 150 described herein, the electric energy storage unit 180 is configured to store a relatively large amount of electrical power. For example, in certain exemplary embodiments, the electric energy storage unit 180 may be configured to store at least about fifty kilowatt hours of electrical power, such as about seventy-five kilowatt hours of electrical power, and up to about one thousand kilowatt hours of electrical power.

The hybrid-electric propulsion system 150 also includes a power management system having a controller 182 and a power bus 184. The electric machines 300A, 300B, the electric energy storage unit 180, and the controller 182 are each electrically connectable to one another through one or more electric lines 186 of the power bus 184.

The controller 182 is configured to control the power electronics to distribute electrical power between the various components of the hybrid-electric propulsion system 150. For example, the controller 182 may control the power electronics of the power bus 184 to provide electrical power to, or draw electrical power from, the various components, such as the electric machines 300A, 300B, to operate the hybrid-electric propulsion system 150 between various operating modes and perform various functions. Such is depicted schematically as the electric lines 186 of the power bus 184 extend through the controller 182.

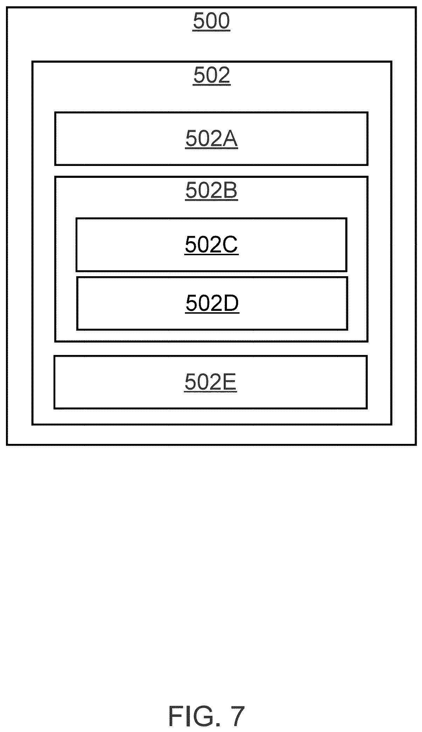

The controller 182 can form a part of a computing system 190 of the aircraft 100. The computing system 190 of the aircraft 100 can include one or more processors and one or more memory devices embodied in one or more computing devices. For instance, as depicted in FIG. 1, the computing system 190 includes controller 182 as well as other computing devices, such as computing device 192. The computing system 190 can include other computing devices as well, such as engine controllers (not shown). The computing devices of the computing system 190 can be communicatively coupled with one another via a communication network. For instance, computing device 192 is located in the cockpit of the aircraft 100 and is communicatively coupled with the controller 182 of the hybrid-electric propulsion system 150 via a communication link 194 of the communication network. The communication link 194 can include one or more wired or wireless communication links. The controller 182 and/or the computing system 190 may be configured similar to the computing system 500 depicted in connection with FIG. 7.

For this embodiment, the computing device 192 is configured to receive and process inputs, e.g., from a pilot or other crew members, and/or other information. In this manner, as one example, the one or more processors of the computing device 192 can receive an input indicating a command to change a thrust output of the first and/or second propulsors 200A, 200B and can cause, in response to the input, the controller 182 to control the electrical power drawn from or delivered to one or both of the electric machines 300A, 300B to ultimately change the thrust output of one or both of the first and second propulsors 200A, 200B.

The controller 182 and other computing devices of the computing system 190 of the aircraft 100 may be configured in substantially the same manner as the exemplary computing devices 500 described below with reference to FIG. 7.

It will be appreciated that the electric machines 300A, 300b, electric energy storage unit 180, and power management system (having the controller 182 and the power bus 184) may more specifically be configured as part of an aeronautical power system integrated with the gas turbine engines of the hybrid-electric propulsion system 150.

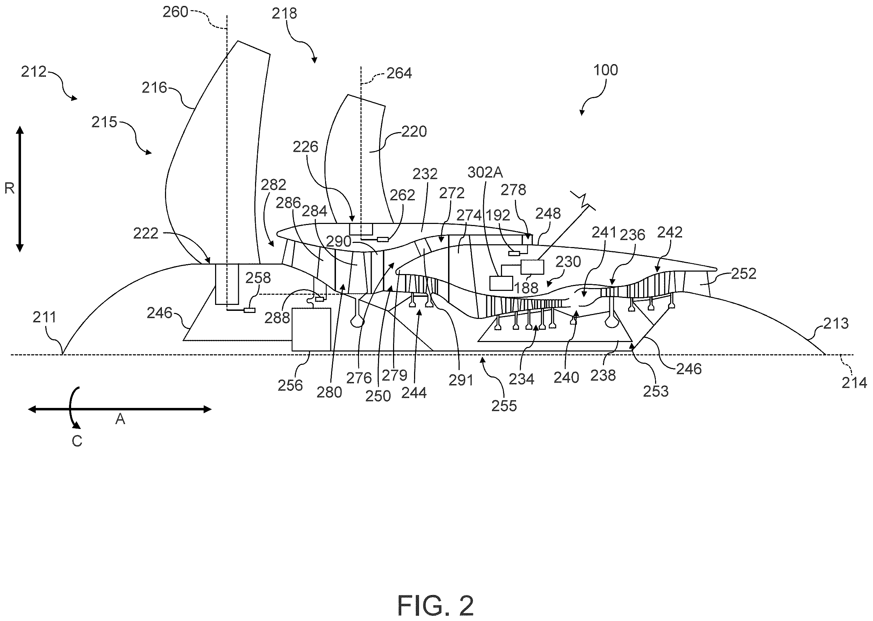

FIG. 2 provides a schematic view of the first propulsor 200A of the hybrid-electric propulsion system 150 of the aircraft 100 of FIG. 1. Although the first propulsor 200A is shown, it will be appreciated that the second propulsor 200B can be configured in the same or similar manner as the first propulsor 200A depicted in FIG. 2. The exemplary gas turbine engine of FIG. 2 is configured as a single unducted rotor engine 210A with a single stage of unducted rotor blades. In such a manner, the rotor assembly may be referred to herein as an "unducted fan." In addition, the gas turbine engine 210A of FIG. 2 includes a third stream extending from the compressor section to a rotor assembly flowpath over the turbomachine, as will be explained in more detail below.

For reference, the gas turbine engine 210A defines an axial direction A, a radial direction R, and a circumferential direction C. Moreover, the gas turbine engine 210A defines an axial centerline or longitudinal axis 214 that extends along the axial direction A. In general, the axial direction A extends parallel to the longitudinal axis 214, the radial direction R extends outward from and inward to the longitudinal axis 214 in a direction orthogonal to the axial direction A, and the circumferential direction extends three hundred sixty degrees (360°) around the longitudinal axis 214. The gas turbine engine 210A extends between a forward end 211 and an aft end 213, e.g., along the axial direction A.

The gas turbine engine 210A includes a turbomachine 230 and a rotor assembly 212, also referred to as a fan section, positioned upstream thereof. Generally, the turbomachine 230 includes, in serial flow order, a compressor section, a combustion section, a turbine section, and an exhaust section. Particularly, as shown in FIG. 2, the turbomachine 230 includes a core cowl 248 that defines an annular core inlet 250. The core cowl 248 further encloses at least in part a low speed or low pressure system and a high speed or high pressure system. For example, the core cowl 248 depicted encloses and supports at least in part a booster or low speed or low pressure compressor 244 for pressurizing the air that enters the turbomachine 230 through core inlet 250. A high speed or high pressure, multi-stage, axial-flow compressor 234 receives pressurized air from the low pressure compressor 244 and further increases the pressure of the air. The pressurized air stream flows downstream to a combustor 240 of the combustion section where fuel is injected into the pressurized air stream and ignited to raise the temperature and energy level of the pressurized air.

It will be appreciated that as used herein, the terms "high/low speed" and "high/low pressure" are used with respect to the high pressure/high speed system and low pressure/low speed system interchangeably. Further, it will be appreciated that the terms "high" and "low" are used in this same context to distinguish the two systems, and are not meant to imply any absolute speed and/or pressure values.

The high energy combustion products flow from the combustor 240 downstream to a high pressure turbine 236. The high pressure turbine 236 drives the high pressure compressor 234 through a high pressure shaft 238. In this regard, the high pressure turbine 236 is drivingly coupled with the high pressure compressor 234. The high speed compressor 234, the high speed turbine 236, and the high speed shaft 238 may collectively be referred to as a high speed spool 253 of the gas turbine engine 210A. The high energy combustion products then flow to a low pressure turbine 242. The low pressure turbine 242 drives the low pressure compressor 244 and components of the rotor assembly 212 through a low pressure shaft 246. In this regard, the low pressure turbine 242 is drivingly coupled with the low pressure compressor 244 and components of the rotor assembly 212. The low speed compressor 244, the low speed turbine 242, and the low pressure shaft 246 may collectively be referred to as a low speed spool 255 of the gas turbine engine 210A. The low pressure shaft 246 is coaxial with the high pressure shaft 238 in this example embodiment. After driving each of the turbines 236, 242, the combustion products exit the turbomachine 230 through a turbomachine exhaust nozzle 252.

Accordingly, the turbomachine 230 defines a working gas flowpath or core duct 241 that extends between the core inlet 250 and the turbomachine exhaust nozzle 252. The core duct 241 is an annular duct positioned generally inward of the core cowl 248 along the radial direction R. The core duct 241 (e.g., the working gas flowpath through the turbomachine 230) may be referred to as a second stream.

The rotor assembly 212 includes a fan 215, which is the primary fan in this example embodiment. For the depicted embodiment of FIG. 2, the fan 215 is an open rotor or unducted fan 215. In such a manner, the gas turbine engine 210A may be referred to as an open rotor engine.

As depicted, the fan 215 includes an array of airfoils arranged around the longitudinal axis 214 of engine 210A, and more particularly includes an array of fan blades 216 (only one shown in FIG. 2) arranged around the longitudinal axis 214 of engine 210A. The fan blades 216 are rotatable, e.g., about the longitudinal axis 214. As noted above, the fan 215 is drivingly coupled with the low pressure turbine 242 via the low pressure shaft 246. For the embodiments shown in FIG. 2, the fan 215 is coupled with the low pressure shaft 246 via a power or speed reduction gearbox 256, e.g., in an indirect-drive or geared-drive configuration.

Moreover, the array of fan blades 216 can be arranged in equal spacing around the longitudinal axis 214. Each fan blade 216 has a proximal end or root 222 and a distal end or tip 224, with respect to the longitudinal axis 214, and a span defined therebetween. Each fan blade 216 defines a pitch change or central blade axis 260. For this embodiment, each fan blade 216 of the rotor assembly 212 is rotatable about its central blade axis 260, e.g., in unison with one another. A pitch change mechanism 258 in the form or one or more actuators is provided to facilitate such rotation and therefore may be used to change a pitch of the fan blades 216 about their respective central blade axes 260.

An array of airfoils positioned aft of the fan blades 216 and also disposed around longitudinal axis 214, and more particularly includes a fan guide vane assembly 218 that includes fan guide vanes 220 (only one shown in FIG. 2) disposed around the longitudinal axis 214. For this embodiment, the fan guide vanes 220 are not rotatable about the longitudinal axis 214. Each fan guide vane 220 has a proximal end or root 226 and a distal end or tip 228, with respect to the longitudinal axis 214, and a span defined therebetween. The fan guide vanes 220 may be unshrouded as shown in FIG. 2 or, alternatively, may be shrouded, e.g., by an annular shroud spaced outward from the tips of the fan guide vanes 220 along the radial direction R or attached to the fan guide vanes 220.

Each fan guide vane 220 defines a central guide vane axis 264. For this embodiment, each fan guide vane 220 of the fan guide vane assembly 218 is rotatable about its respective central guide vane axis 264, e.g., in unison with one another. One or more pitch change mechanisms 262 in the form of one or more actuators are provided to facilitate such rotation and therefore may be used to change a pitch of the fan guide vane 220 about its respective central guide vane axis 264. However, in other embodiments, each fan guide vane 220 may be fixed or unable to be pitched about its central guide vane axis 264. The fan guide vanes 220 are mounted to a fan cowl 232.

As shown in FIG. 2, in addition to the fan 215, which is unducted, a ducted fan 284 is included aft of the fan 215, such that the gas turbine engine 210A includes both a ducted and an unducted fan which both serve to generate thrust through the movement of air without passage through at least a portion of the turbomachine 230 (e.g., without passage through the high pressure compressor 234 and combustion section for the embodiment depicted). The ducted fan 284 is rotatable about the same axis (e.g., the longitudinal axis 214) as the fan blade 216. The ducted fan 284 is, for the embodiment depicted, driven by the low pressure turbine 242 (e.g. coupled to the low pressure shaft 246). In the embodiment depicted, as noted above, the fan 215 may be referred to as the primary fan, and the ducted fan 284 may be referred to as a secondary fan. It will be appreciated that these terms "primary" and "secondary" are terms of convenience, and do not imply any particular importance, power, or the like.

The ducted fan 284 includes a plurality of fan blades (not separately labeled in FIG. 2) arranged in a single stage, such that the ducted fan 284 may be referred to as a single stage fan. The fan blades of the ducted fan 284 can be arranged in equal spacing around the longitudinal axis 214. Each blade of the ducted fan 284 has a proximal end or root and a distal end or tip and a span defined therebetween.

The fan cowl 232 annularly encases at least a portion of the core cowl 248 and is generally positioned outward of at least a portion of the core cowl 248 along the radial direction R. Particularly, a downstream section of the fan cowl 232 extends over a forward portion of the core cowl 248 to define a fan duct flowpath, or simply a fan duct 272. According to this embodiment, the fan flowpath or fan duct 272 may be understood as forming at least a portion of the third stream of the engine 210A.

Incoming air may enter through the fan duct 272 through a fan duct inlet 276 and may exit through a fan exhaust nozzle 278 to produce propulsive thrust. The fan duct 272 is an annular duct positioned generally outward of the core duct 241 along the radial direction R. The fan cowl 232 and the core cowl 248 are connected together and supported by a plurality of substantially radially-extending, circumferentially-spaced stationary struts 274 (only one shown in FIG. 2). The stationary struts 274 may each be aerodynamically contoured to direct air flowing thereby. Other struts in addition to the stationary struts 274 may be used to connect and support the fan cowl 232, the core cowl 248, or both. In many embodiments, the fan duct 272 and the core duct 241 may at least partially co-extend (generally axially) on opposite sides (e.g., opposite radial sides) of the core cowl 248. For example, the fan duct 272 and the core duct 241 may each extend directly from a leading edge 279 of the core cowl 248 and may partially co-extend generally axially on opposite radial sides of the core cowl 248.

The gas turbine engine 210A also defines or includes an inlet duct 280. The inlet duct 280 extends between an engine inlet 282 and the core inlet 250 and fan duct inlet 276. The engine inlet 282 is defined generally at the forward end of the fan cowl 232 and is positioned between the fan 215 and the fan guide vane assembly 218 along the axial direction A. The inlet duct 280 is an annular duct that is positioned inward of the fan cowl 232 along the radial direction R. Air flowing downstream along the inlet duct 280 is split, not necessarily evenly, into the core duct 241 and the fan duct 272 by a fan duct splitter or leading edge 279 of the core cowl 248. In the embodiment depicted, the inlet duct 280 is wider than the core duct 241 along the radial direction R. The inlet duct 280 is also wider than the fan duct 272 along the radial direction R.

Notably, for the embodiment depicted, the engine 210A includes one or more features to increase an efficiency of a third stream thrust, Fn_{3S} (e.g., a thrust generated by an airflow through the fan duct 272 exiting through the fan exhaust nozzle 278, generated at least in part by the ducted fan 284). In particular, the engine 210A further includes an array of inlet guide vanes 286 positioned in the inlet duct 280 upstream of the ducted fan 284 and downstream of the core inlet 250. The array of inlet guide vanes 286 are arranged around the longitudinal axis 214. For this embodiment, the inlet guide vanes 286 are not rotatable about the longitudinal axis 214. Each inlet guide vane 286 defines a central blade axis (not labeled for clarity), and is rotatable about its respective central blade axis, e.g., in unison with one another. In such a manner, the inlet guide vanes 286 may be considered a variable geometry component. One or more actuators 288 are provided to facilitate such rotation and therefore may be used to change a pitch of the inlet guide vanes 286 about their respective central blade axes. However, in other embodiments, each inlet guide vane 286 may be fixed or unable to be pitched about its central blade axis.

Further, located downstream of the ducted fan 284 and upstream of the fan duct inlet 276, the gas turbine engine 210A includes an array of outlet guide vanes 290. As with the array of inlet guide vanes 286, the array of outlet guide vanes 290 are not rotatable about the longitudinal axis 214. However, for the embodiment depicted, unlike the array of inlet guide vanes 286, the array of outlet guide vanes 290 are configured as fixed-pitch outlet guide vanes.

Further, it will be appreciated that for the embodiment depicted, the fan exhaust nozzle 278 of the fan duct 272 is further configured as a variable geometry exhaust nozzle 278. In such a manner, the engine 210A includes one or more actuators 292 for modulating the variable geometry exhaust nozzle 278. For example, the variable geometry exhaust nozzle 278 may be configured to vary a total cross-sectional area (e.g., an area of the nozzle in a plane perpendicular to the longitudinal axis 214) to modulate an amount of thrust generated based on one or more engine operating conditions (e.g., temperature, pressure, mass flowrate, etc. of an airflow through the fan duct 272). A fixed geometry exhaust nozzle may also be adopted.

Moreover, referring still to FIG. 2, in exemplary embodiments, air passing through the fan duct 272 may be relatively cooler (e.g., lower temperature) than one or more fluids utilized in the turbomachine 230. In this way, one or more heat exchangers 291 may be positioned in thermal communication with the fan duct 272. For example, one or more heat exchangers 291 may be disposed within the fan duct 272 and utilized to cool one or more fluids from the core engine with the air passing through the fan duct 272, as a resource for removing heat from a fluid, e.g., compressor bleed air, oil or fuel.

Referring still to FIG. 2, as noted, the first propulsor 200A includes electric machine 300A operably coupled with a rotating component thereof. In this regard, the first propulsor 200A is an aeronautical hybrid-electric propulsion machine. Particularly, as shown in FIG. 2, the electric machine 300A is mechanically coupled with the low speed spool 255 of the gas turbine engine 210A, and more particularly, the low pressure shaft 246 of the low speed spool 255. As depicted, the electric machine 300A is embedded within the core of the gas turbine engine 210A. Specifically, the electric machine 300A is positioned inward of the core duct 241 along the radial direction R. Moreover, for this embodiment, the electric machine 300A is positioned generally at the aft end of the gas turbine engine 210A and is at least partially overlapping with or aft of the low pressure turbine 242 along the axial direction A.

However, in other exemplary embodiments, the electric machine 300A may be positioned at other suitable locations within the gas turbine engine 210A. For instance, in some embodiments, the electric machine 300A can be coupled with the low speed spool 255 in other suitable locations. For instance, in some embodiments, the electric machine 300A can be positioned forward of the low pressure compressor 244 along the axial direction A and inward of the turbomachinery flowpath 254 along the radial direction R. Further, as shown in FIG. 2, the electric machine 300A mechanically coupled with the low pressure shaft 246 is electrically coupled with the power bus 184.

In addition or alternatively to the gas turbine engine 210A having electric machine 300A coupled to the low speed spool 255, in the embodiment depicted in FIG. 2, the gas turbine engine 210A further includes an electric machine 302A mechanically coupled with the high speed spool 253 of the gas turbine engine 210A, and, more particularly, the high speed shaft 238 of the high speed spool 253. As depicted in FIG. 2, the electric machine 302A is mechanically coupled with the high speed shaft 238 through a mechanical linkage. The electric machine 302A is positioned outward of the core duct 241 along the radial direction R and is positioned forward of the combustion section of the gas turbine engine 210A along the axial direction A.

However, in other exemplary embodiments, the electric machine 302A may be positioned at other suitable locations within the gas turbine engine 210A (e.g., inward of the core duct 241 along the radial direction R).

Like the electric machine 300A mechanically coupled with the low speed spool 255, the electric machine 302A mechanically coupled with the high speed spool 253 can be an electric motor operable to drive or motor the high speed shaft 238, e.g., during a starting operation of the gas turbine engine 210A. In other embodiments, the electric machine 302A can be an electric generator operable to convert mechanical energy into electrical energy. In this way, electrical power generated by the electric machine 302A can be directed to various engine and/or aircraft systems. In some embodiments, the electric machine 302A can be a motor/generator with dual functionality.

Further, as shown in FIG. 2, the electric machine 302A mechanically coupled with the high speed shaft 238 is also electrically coupled with the power bus 184. More specifically, the aeronautical power system may include a power electronics assembly 188 located between the electric machines 300A, 302A and the power bus 184. The power electronics assembly 188 may comprise one or more power inverters, power controllers, or other types of electronic components in electric connection with one or more electric power loads, electric power sources, or both (e.g., of the engine or the aircraft, or both).

Additionally or alternatively, in other exemplary embodiments, any other suitable gas turbine engine may be provided. For example, in other exemplary embodiments, the gas turbine engine may be a turboshaft engine, a turboprop engine, turbojet engine, etc. Moreover, for example, although the engine is depicted as a single unducted rotor engine, in other embodiments, the engine may include a multi-stage open rotor configuration, and aspects of the disclosure described hereinbelow may be incorporated therein.

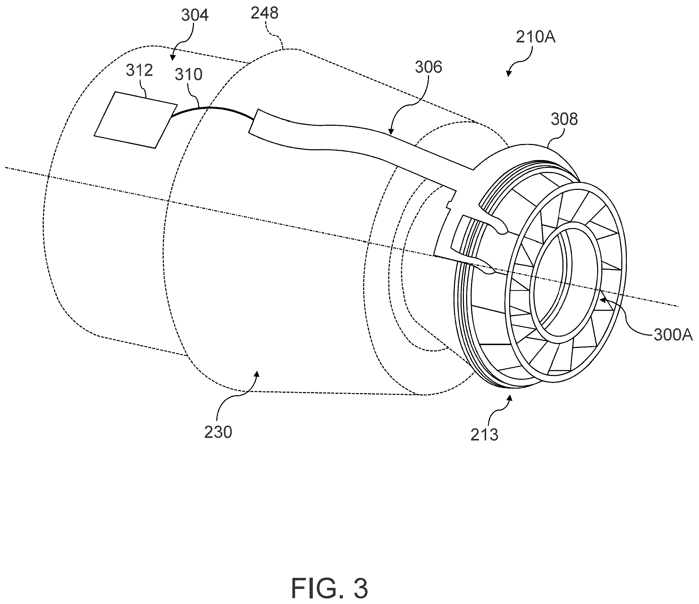

Referring to FIG. 3, a perspective view of a portion of the gas turbine engine 210A is illustrated diagrammatically and generally describes an electrical system 304 and a portion of a thermal management system 306. The electrical system 304 includes the electrical machine 300A disposed in the aft end 213 of the gas turbine engine 210A. The electrical machine 300A converts mechanical energy (e.g., generated from exhaust gases generated in the turbomachine 230 (FIG. 2) produced by the gas turbine engine 210A into electrical energy that may be used to power electrical devices of the gas turbine engine 210A or components disposed elsewhere on an aircraft incorporating the gas turbine engine 210A.

The electrical system 304 includes a connection assembly 308 that is routed through the thermal management system 306. The thermal management system 306 may be configured to provide cooling to the electrical machine 300A. The connection assembly 308 includes a plurality of electrical connectors 310 (e.g., power cables) that conductively connect the electrical machine 300A to a power converter 312. For example, the electrical machine 300A may generate an alternating current ("AC") power signal from mechanical energy in the spinning low-pressure shaft 246 (FIG. 2), which electrical power is routed to the power converter 312 (located in the forward part of the engine) via the connection assembly 308. The power converter 312 may generate a DC voltage from the AC power signal for communication to alternative locations on the aircraft (e.g., via an electrical communications bus). The structure of the power converter 312 and connection assembly 308 may vary depending, at least in part, on the structure and capabilities of the electrical machine 300A. For example, in various embodiments, the electrical machine 300A may generate an AC power signal having any number of phases (e.g., one phase, two phases, three phases, four phases, etc.). It should be understood that embodiments of the present disclosure may be used in any type of power converter that is used to convert electrical energy from one form to another such as, by way of non-limiting example, a conversion from AC to DC, a conversion from DC to AC, a DC-DC power converter to step up or step down a DC voltage level, or an AC-to-AC power converter to convert an alternating current waveform from one form to another.

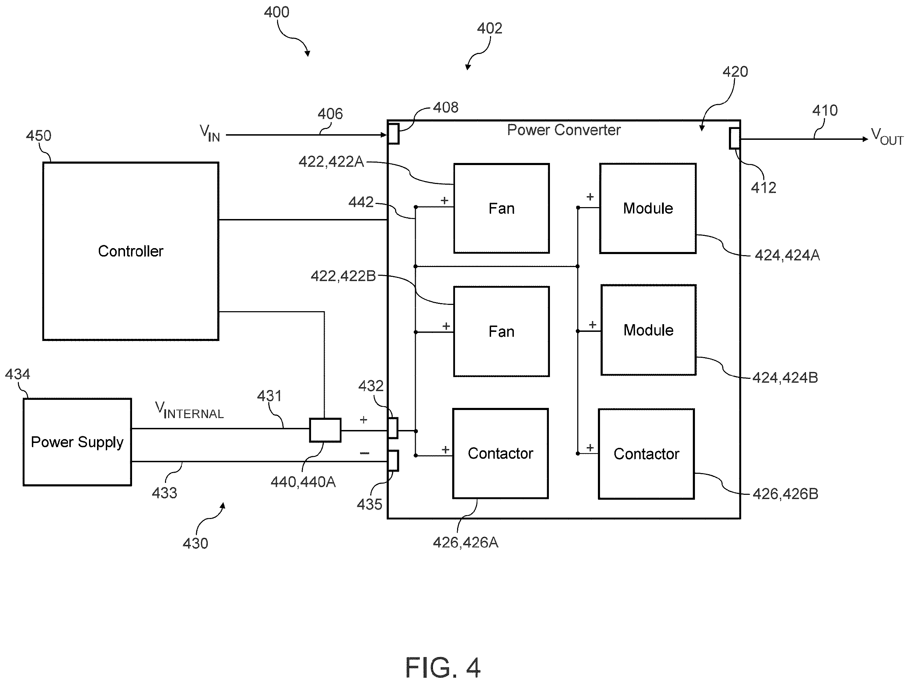

Referring to FIG. 4, an exemplary embodiment of a diagnostic system 400 is schematically depicted. In the embodiment illustrated in FIG. 4, the diagnostic system 400 is operably associated with a power converter 402 to determine and/or assess a health status of the power converter 402. The power converter 402 may be the power converter 312 (FIG. 3) or may be a different power converter electrically connected to another electrical system of the aircraft 100 (FIG. 1). In the embodiment depicted in FIG. 4, an input power line 406 may be electrically coupled to an input terminal 408 of the power converter 402 for receiving an input electric energy (V_{IN}) which is acted upon or converted by the power converter 402 to provide electric energy (V_{OUT}) to a load at a desired output voltage and current. Accordingly, the power converter 402 may also include an output power line 410 electrically coupled to an output terminal 412 of the power converter 402 to output the converted electric energy (V_{OUT}).

In exemplary embodiments, the power converter 402 may include one or more subsystems 420 of the power converter 402. The one or more subsystems 420 may be electric circuits and/or electronic components or component assemblies that are used to perform a power conversion process and/or are used to perform one or more non-conversion functions such as, by way of non-limiting example, cooling the power converter 402. In the embodiment illustrated in FIG. 4, the one or more subsystems 420 include one or more fans 422, one or more switching modules 424, and one or more contactors 426. In FIG. 4, two fans 422A, 422B, two switching modules 424A, 424B, and two contactors 426A, 426B are depicted. However, it should be understood that the quantity of fans 422, switching modules 424, and contactors 426 may be greater or fewer. Additionally, the one or more subsystems 420 may include additional and/or other types of components, component assemblies, and/or circuits depending at least on the type or function of the power converter 402. The one or more fans 422 may be used to cool the power converter 402. The one or more switching modules 424 may include electronic switches and/or circuitry in the form of semiconductor components such as, by way of non-limiting example, transistors and thyristors, along with control circuitry. The one or more contactors 426 may be used to electrically connect or disconnect a current flow between components or circuits in the power converter 402.

In exemplary embodiments, a power line 430 is electrically coupled to the power converter 402 for receiving electrical energy such as a voltage supply (V_{INTERNAL}) to power internal components of the power converter 402 such as, by way of non-limiting example, the subsystems 420. In exemplary embodiments, the voltage supply V_{INTERNAL} is supplied by a power supply 434 via an electrically positive input line 431 electrically connected to an input terminal 432 of the power converter 402, and an electrically negative output line 433 is electrically connected to an output terminal 435 of the power converter 402. The power supply 434 generally supplies a low voltage (e.g., 28 volts) because the subsystems 420 generally operate on a lower voltage level (i.e., lower than a voltage that may be converted). However, it should be understood that another voltage level may be used to power the subsystems 420 of the power converter 402. A power bus 442 is electrically connected to the input terminal 432 and is electrically connected to the one or more subsystems 420 for delivering electrical energy to the one or more subsystems 420.

In exemplary embodiments, one or more sensors 440 may be electrically coupled to the power line 430. The one or more sensors 440 may be any type of sensor and/or measurement device capable of detecting one or more electrical characteristics corresponding to the power line 430 such as, by way of non-limiting example, a voltage and/or a current. In the embodiment illustrated in FIG. 4, the one or more sensors 440 are electrically connected to the electrically positive input line 431.

In the embodiment illustrated in FIG. 4, a controller 450 may be electrically and/or communicatively coupled to at least the power converter 402 and the one or more sensors 440. The controller 450 may be the same controller as the controller 182 (FIG. 1) or may be a separate or independent controller corresponding to the power converter 402 and/or one or more other electric components. The controller 450 may receive data from a variety of inputs (e.g., including the one or more sensors 440), may make control decisions, perform health assessment operations, and/or and may provide data (e.g., instructions) to a variety of input interfaces to various components (e.g., including the power converter 402). The controller 450 may be configured in substantially the same manner as the exemplary computing system 500 and computing devices 502 described below with reference to FIG. 7.

In operation, the power converter 402 performs a start-up sequence of the one or more subsystems 420 such as, by way of non-limiting example, during a power-on built-in test (PBIT) of the power converter 402. The power converter 402 may be configured to automatically perform the star-up sequence and/or the controller 450 may initiate and/or instruct the power converter 402 to performs a start-up sequence. In exemplary embodiment, the start-up sequence may include sequentially enabling the subsystems 420. The start-up sequence may include sequentially enabling the fan 422A, followed by enabling the fan 422B, followed by performing a switching sequence of the switching module 424A, followed by performing a switching sequence of the switching module 424B, followed by a closing and an opening of the contactor 426A, followed by a closing and an opening of the contactor 426B, etc. It should be understood that the order or sequence of the enablement of the subsystems 420 may vary.

The controller 450 stores or otherwise includes data associated with the start-up sequence of the subsystems 420 such that the controller 450 can correlate various detected or measured electrical characteristics (e.g., via the one or more sensors 440) to a particular subsystem 420. In exemplary embodiments, the one or more sensors 440 may be used to measure at least a current parameter associated with a particular subsystem 420 based on the current flow to that subsystem 420 during the start-up sequence such as, by way of non-limiting example, a rise time, a current draw, or a settling time of the current flowing to the particular subsystem 420. Because the start-up sequence includes a predefined or choregraphed start-up of the subsystems 420, the controller 450 can evaluate current transients during the start-up sequence for each corresponding subsystem 420. The controller 450 may evaluate and/or compare the measured or detected current data with respect to baseline and/or expected current data values, current value thresholds, and/or evaluated for current values trending toward critical maintenance indications to determine whether a current anomaly is indicated. A "current anomaly" may be a deviation from standard operating characteristics based on the particular subsystem 420.

In exemplary embodiments, the controller 450 may detect a current anomaly based on a current draw during the start-up sequence nearing, meeting, and/or exceeding or overshooting a baseline or expected current value for the particular subsystem 420. The controller 450 may detect a current anomaly based on a rise time or rise characteristic of the current flowing to the particular subsystem 420 during the start-up sequence nearing, meeting, and/or exceeding a baseline or expected rise time value. The controller 450 may further detect a current anomaly based on a current settling time or current drop-off of the current flowing to the particular subsystem 420 during the start-up sequence nearing, meeting, and/or exceeding a baseline or expected value. The predefined thresholds may be stored in the memory 502B as data 502D (FIG. 7). In exemplary embodiments, in response to a measured current parameter exceeding a baseline and/or expected current data values, current value thresholds, and/or current values trending toward critical maintenance indications, the controller 450 may be configured to output an indication of the current anomaly affecting a health status of the particular subsystem 420. By way of non-limiting example, the output may be an audio alert, visual alert (e.g., displayed on a display screen or other output device), an electronic communication, an update to a tracked lifespan of the particular subsystem 420 or the power converter 402, or other type of health status indication.

Upon completion of the start-up sequence, the power converter 402 may automatically enter a run mode. In the run mode, the power converter 402 is enabled to perform a power conversion process (e.g., enabled to receive the input electric energy (V_{IN}) which is acted upon or converted by the power converter 402 to provide electric energy (V_{OUT}) to a load at a desired output voltage and current. In exemplary embodiments, the controller 450 may continue monitoring one or more electrical characteristics corresponding to the power line 430 as in the start-up sequence. Although a plurality of the subsystems 420 may be concurrently operating during the run mode, the controller 450 may evaluate and/or compare the monitored and detected electrical characteristics corresponding to the power line 430 during the run mode to corresponding baseline and/or expected current data values, current value thresholds, and/or current values trending toward critical maintenance indications associated with the rune mode operating aspects of the power converter 402.

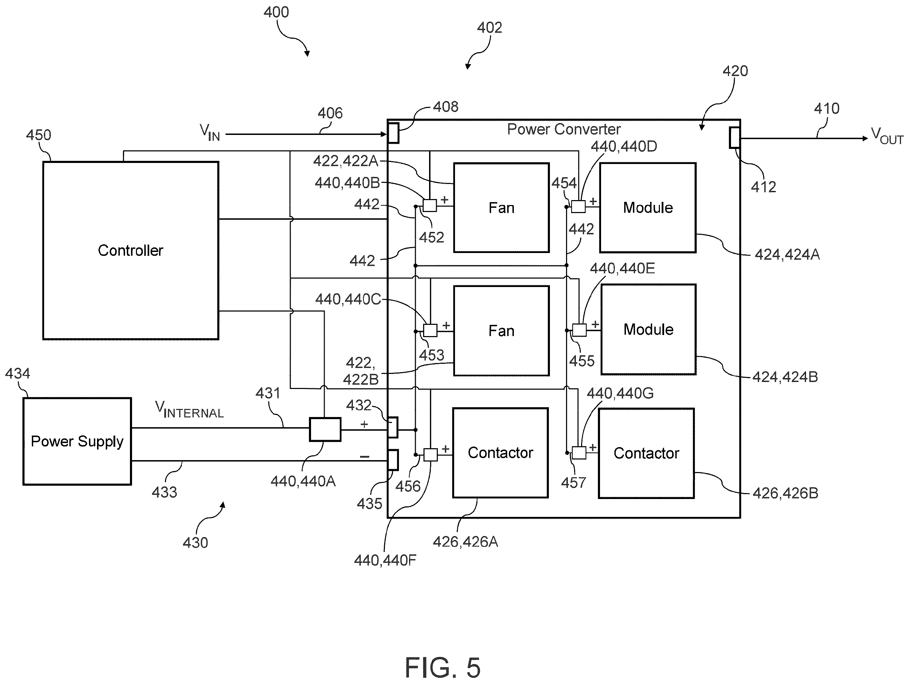

FIG. 5 depicts the diagnostic system 400 according to another exemplary embodiment of the present disclosure. The power converter 402 may be configured similar to the power converter 402 depicted in FIG. 4, like reference numerals referring to similar structures as discussed pursuant to the exemplary embodiment depicted in FIG. 4 and will not be repeated in furtherance of brevity. In FIG. 5, the diagnostic system 400 includes the sensor 440A and one or more additional sensors 440 each dedicated to a particular subsystem 420. In exemplary embodiments, the power bus 442 is electrically connected to the input terminal 432. An input line 452 is electrically connected to the power bus 442 and to the fan 422A, and a sensor 440B is electrically coupled to the input line 452. An input line 453 is electrically connected to the power bus 442 and to the fan 422B, and a sensor 440C is electrically connected to the input line 453. An input line 454 is electrically connected to the power bus 442 and to the switch module 424A, and a sensor 440D is electrically connected to the input line 454. An input line 455 is electrically connected to the power bus 442 and to the switch module 424B, and a sensor 440E is electrically connected to the input line 454. An input line 456 is electrically connected to the power bus 442 and to the contactor 426A, and a sensor 440F is electrically connected to the input line 456. An input line 457 is electrically connected to the power bus 442 and to the contactor 426B, and a sensor 440G is electrically connected to the input line 457. The input lines 452-457 are electrically positive input lines. The electrically negative lines are omitted from FIG 5 for ease of illustration and description.

Thus, each of the sensors 440B-440G are electrically coupled to the power bus 442 which receives power via the input line 431 providing power (V_{INTERNAL}) to the respective subsystem 420, and the controller 450 is electrically and/or communicatively connected to each of the sensors 440B-440G. Thus, during the start-up sequence as depicted in connection with FIG. 4, or during a run mode operating state of the power converter 402, the one or more sensors 440B-440G are configured to detect one or more electrical characteristics corresponding to its dedicated subsystem 420 and communicate the detected information to the controller 450. The controller 450 is configured to assess the detected power information and assess a health condition of the particular subsystem 420 at least because the controller 450 is configured to correlate data received from each of the sensors 440B-440G to a particular subsystem 420. As indicated above in connection with FIG. 4, the controller 450 is configured to evaluate and/or compare the measured or detected current data with respect to baseline and/or expected current data values, current value thresholds, and/or evaluated for current values trending toward critical maintenance indications to determine whether a current anomaly is indicated by the received data.

In exemplary embodiments, the one or more sensors 440 can be located remote from the power converter 402 such as, by way of non-limiting example, anywhere inline from the power supply 434 to the power converter 402 (e.g., such as the sensor 440A as depicted in FIG. 4 electrically connected to the power line 430). Additionally or alternatively, the power converter 402 may include one or more of the sensors 440 dedicated to respective subsystems 420 (e.g., such as the one or more sensors 440B-440G depicted in FIG. 5). Thus, it should be understood that embodiments of the diagnostic system 400 depicted in FIG. 5 may be configured such that the sensor 440A is omitted. In other words, the diagnostic system 400 may include the sensor 440A in combination with the sensors 440B-440G as depicted in FIG. 5, solely the sensor 440A as depicted in FIG. 4, or solely the sensors 440B-440G. In exemplary embodiments, configuring the diagnostic system 400 with the sensors 440B-440G may enable the diagnostic system 400 to more accurately correlate measured current parameters to individual subsystems 420 during start-up and/or run modes of operation.

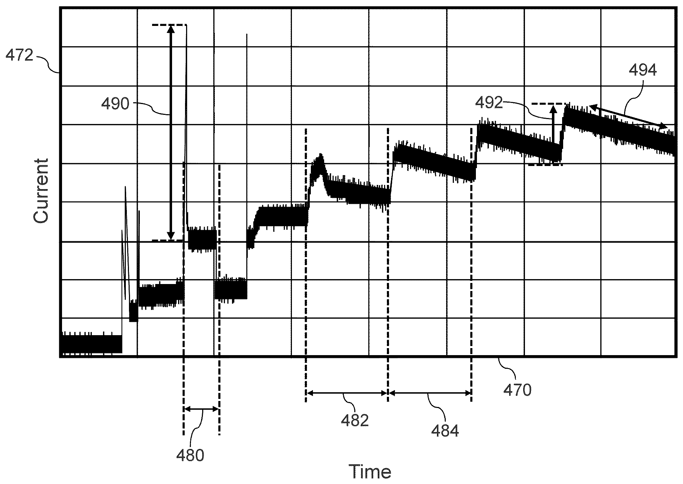

FIG. 6 depicts a graphical illustration of electrical responses or current transients corresponding to individual subsystems 420 of the power converter 402 (FIGS. 4 and 5) in accordance with an embodiment of the present disclosure. In FIG. 6, the horizontal axis 470 represents time, and the vertical axis 472 represents current values. The graphical illustration of FIG. 6 depicts a start-up sequence of the subsystems 420 and associated current measurements detected by the one or more sensors 440 (FIGS. 4 and 5). As depicted in FIG. 6, the start-up sequence may include one or more functional checks and/or enabling one or more of the subsystems 420 according to a choregraphed sequence such that current measurements may be detected and correlated to each respective subsystem 420. By way of non-limiting example, the region 480 may correspond to a functional check of the switching module 424A, the region 482 may correspond to an enabling or power-on of the fan 422A, the region 484 may correspond to an enabling or opening/closing the contactor 426A, etc. During the start-up sequence, the enabling and/or functional checks of the one or more subsystems 420 may occur at different time periods during the startup-up sequence such that measured or detected current parameters may be correlated by the controller 450 to the particular subsystem 420. As depicted in FIG. 6, one or more current characteristics can be measured and/or detected during the start-up sequence by the one or more sensors 440 such as, by way of non-limiting example, a current value overshoot 490 corresponding to a current draw of a particular subsystem 420 occurring during an enabling, power-on, and/or functional check of such subsystem 420, a current rise time 492 occurring during an enabling, power-on, and/or functional check of a particular subsystem 420, and/or a current drop-off time or settling time 494 occurring during an enabling, power-on, and/or functional check of a particular subsystem 420. In exemplary embodiments, the step-wise nature of the current buildup, as depicted in FIG. 6, is due to the sequential and choreographed start-up of the subsystems 420 that enables an individual assessment of the health of a respective subsystem 420. By way of non-limiting example, trends in a rate of inrush current or an overshoot to a steady state may indicate a degradation of capacitor health (e.g., a change in the); trends in a steady state current level may indicate a loss of a device (e.g., a gate driver loss if when the steady state current draw id a defined percentage below an expected value); trends in a steady state current level may indicate an anticipated failure of a device (e.g., a bearing or motor of a fan causing a greater current draw); a trend in settling time may indicate a change in parasitic/filter device health or status; and a rising trend during steady state may indicate an overheating condition causing reduced efficiency and potentially accelerated lifing of a component. Further, the controller 450 may evaluate gate driver current draw, either using a startup sequence as mentioned above, trending during an entire non-startup stage together by bulk current draw, or by using current sensors dedicated for each gate driver for continuous individual monitoring (e.g., as depicted and described in connection with FIG. 5).

FIG. 7 provides an example computing system 500 according to example embodiments of the present disclosure. The computing devices or elements described herein, such as the controllers 182 and 450, may include various components and perform various functions of the computing system 500 described below, for example.

As shown in FIG. 7, the computing system 500 can include one or more computing device(s) 502. The computing device(s) 502 can include one or more processor(s) 502A and one or more memory device(s) 502B. The one or more processor(s) 502A can include any suitable processing device, such as a microprocessor, microcontroller, integrated circuit, logic device, and/or other suitable processing device. The one or more memory device(s) 502B can include one or more computer-executable or computer-readable media, including, but not limited to, non-transitory computer-readable media, RAM, ROM, hard drives, flash drives, and/or other memory devices.

The one or more memory device(s) 502B can store information accessible by the one or more processor(s) 502A, including computer-readable instructions 502C that can be executed by the one or more processor(s) 502A. The instructions 502C can be any set of instructions that when executed by the one or more processor(s) 502A, cause the one or more processor(s) 502A to perform operations. In some embodiments, the instructions 502C can be executed by the one or more processor(s) 502A to cause the one or more processor(s) 502A to perform operations, such as any of the operations and functions for which the computing system 500 and/or the computing device(s) 502 are configured, such as initiating a start-up sequence or run mode of the power converter 402, detecting, measuring, and/or analyzing current parameters detected during the start-up sequence or run mode of the power converter 402, and/or outputting an alert indication identifying a present or anticipated current anomaly. The instructions 502C can be software written in any suitable programming language or can be implemented in hardware. Additionally, and/or alternatively, the instructions 502C can be executed in logically and/or virtually separate threads on processor(s) 502A. The memory device(s) 502B can further store data 502D that can be accessed by the processor(s) 502A. For example, the data 502D can include models, lookup tables, databases, etc.

The computing device(s) 502 can also include a network interface 502E used to communicate, for example, with the other components of the computing system 500 (e.g., via a communication network). The network interface 502E can include any suitable components for interfacing with one or more network(s), including for example, transmitters, receivers, ports, controllers, antennas, and/or other suitable components. One or more devices can be configured to receive one or more commands from the computing device(s) 502 or provide one or more commands to the computing device(s) 502.

The technology discussed herein makes reference to computer-based systems and actions taken by and information sent to and from computer-based systems. It will be appreciated that the inherent flexibility of computer-based systems allows for a great variety of possible configurations, combinations, and divisions of tasks and functionality between and among components. For instance, processes discussed herein can be implemented using a single computing device or multiple computing devices working in combination. Databases, memory, instructions, and applications can be implemented on a single system or distributed across multiple systems. Distributed components can operate sequentially or in parallel.

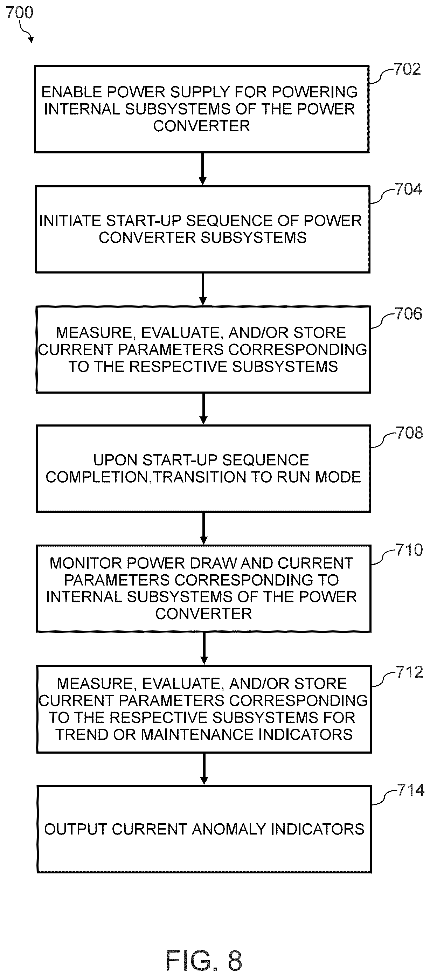

Referring to FIG. 8, a flow diagram depicting a method 700 for health diagnostics for a power converter is illustrated. The method 700 may be applicable to the power converter 402 or any other power converter of the aircraft 100 (FIG 1). The method 700 begins at 702, where a power supply (e.g., power supply 434) for powering the internal subsystems 420 of the power converter 402 is enabled. At 704, the method 700 includes initiating a start-up sequence of the subsystems 420 of the power converter 402. By way of non-limiting example, the subsystems 420 of the power converter 402 may be initiated or started according to a defined sequence. At 706, the method 700 includes measuring, evaluating, and/or storing current parameters corresponding to the respective subsystems 420. By way of non-limiting example, the controller 450 may receive or obtain data from one or more of the sensors 440 as to various current parameter measurements associated with a particular subsystem 420 during the start-up sequence. The measured or detected current parameters may include, by way of non-limiting example, a rise time, a current draw, or a settling time of the current flowing to the particular subsystem 420.

At 708, the method 700 includes, upon start-up sequence completion, transitioning to a run mode of the power converter 402. By way of non-limiting example, upon completion of a start-up sequence of the subsystems 420, the power converter 402 may transition to a run mode operating condition where the power converter 402 is enabled to perform a power conversion process (e.g., enabled to receive the input electric energy (V_{IN}) which is acted upon or converted by the power converter 402 to provide electric energy (V_{OUT}) to a load at a desired output voltage and current). At 710, the method 700 includes monitoring a power draw and current parameters corresponding to the internal subsystems 420 of the power converter 402 during a run mode of operation. By way of non-limiting example, the controller 450 may receive or obtain data from one or more of the sensors 440 (e.g., sensors 440A-440G) as to various current parameter measurements associated with a particular subsystem 420. At 712, the method 700 includes measuring, evaluating, and/or storing measured current parameters corresponding to the respective subsystems 420 for trend or maintenance indications. By way of non-limiting example, the controller 450 may may evaluate and/or compare the measured or detected current data with respect to baseline and/or expected current data values, current value thresholds, and/or evaluated for current values trending toward critical maintenance indications to determine whether a current anomaly is indicated. At 714, the method 700 includes outputting, by the controller 450, any current anomaly indications. By way of non-limiting example, the controller 450 may output an alert indication identifying a present or anticipated current anomaly, identifying a particular subsystem 420 associated with the detected or anticipated current anomaly, identifying a suspected cause of the present or anticipated current anomaly, or other data indicating a critical maintenance condition affecting a health status of a particular subsystem 420 or component of a particular subsystem 420. It should be understood that 714 may be performed at any time during the method 700 upon a detection of a current anomaly.

Thus, exemplary embodiments of the present disclosure provide an improved detection capability of failures, including advanced notice of components trending toward needed maintenance. Embodiments of the present disclosure isolate anomalies to specific subsystems of the power converter via specific start-up sequencing and trending of power draw characteristics with operating conditions of the power converter. Embodiments of the present disclosure may include a single low-power current sensor for the purpose of detecting current anomalies and/or may include additional sensors for specific subsystems to further improve the diagnostic accuracy.

Further aspects are provided by the subject matter of the following clauses:
A diagnostic system for an aeronautical power system, the diagnostic system comprising: a power converter electrically connected to an electrical system of an aircraft; a power supply connected to the power converter via an input line, the power converter configured to receive electrical energy via the input line to power one or more subsystems of the power converter; one or more sensors electrically connected to the input line; and a controller electrically connected to the power converter and the one or more sensors, the controller configured to: monitor, during a start-up sequence of the one or more subsystems, a current flowing through the input line via the one or more sensors during at least a portion of the start-up sequence; and analyze the current to determine a health status of at least one subsystem of the one or more subsystems.

The diagnostic system of the previous clause, wherein the one or more subsystems comprise at least one of a fan, a switching module, or a contactor.

The diagnostic system of any previous clause, wherein the controller is configured to determine at least one of a current rise time, a current draw, or a current settling time with respect to the at least one subsystem.

The diagnostic system of any previous clause, wherein the controller is configured to compare the at least one of the current rise time, the current draw, or the current settling time to a threshold.

The diagnostic system of any previous clause, wherein the controller is configured to, after a completion of the start-up sequence, monitor the current during a run mode of the power converter.

The diagnostic system of any previous clause, wherein the controller is configured to store data corresponding to the current flowing through the input line during the start-up sequence.

The diagnostic system of any previous clause, wherein the controller is configured to correlate the data to a respective subsystem.

The diagnostic system of any previous clause, wherein the controller is configured to determine whether the data indicates a trend.

The diagnostic system of any previous clause, wherein the one or more sensors comprise at least one sensor located remote from the power converter.

The diagnostic system of any previous clause, wherein the input line comprises a first input line, and wherein the power converter comprises a power bus electrically coupled to the first input line, wherein the power bus is configured to deliver the electrical energy to the one or more subsystems via one or more respective second input lines, and wherein the one or more current sensors are electrically coupled to the one or more second input lines.

A method for diagnostic analysis of a power converter electrically connected to an electrical system of an aircraft, the method comprising: initiating a start-up sequence of one or more subsystems of the power converter; monitoring, during at least a portion of the start-up sequence, a current flowing through an input line electrically connected to the power converter, wherein the power converter receives electrical energy via the input line to power the one or more subsystems; and analyzing the current to determine a health status of at least one subsystem of the one or more subsystems.

The method of any previous clause, further comprising determining at least one of a current rise time, a current draw, or a current settling time with respect to the at least one subsystem.

The method of any previous clause, further comprising comparing the at least one of the current rise time, the current draw, or the current settling time to a threshold.

The method of any previous clause, further comprising, after a completion of the start-up sequence, monitoring the current during a run mode of the power converter.

The method of any previous clause, further comprising storing data corresponding to the current flowing through the input line during the start-up sequence.

The method of any previous clause, further comprising correlating the data to a respective subsystem.

The method of any previous clause, further comprising determining whether the data indicates a trend.

A non-transitory computer-readable medium comprising computer-executable instructions, which when executed by a processor associated with a controller, cause the controller to perform a method for diagnostic analysis of a power converter electrically connected to an electrical system of an aircraft, the method comprising: monitoring, during at least a portion of a start-up sequence of one or more subsystems of the power converter, a current flowing through an input line electrically connected to the power converter, wherein the power converter receives electrical energy via the input line to power the one or more subsystems; and analyzing the current to determine a health status of at least one subsystem of the one or more subsystems.

The non-transitory computer-readable medium of any previous clause, wherein the computer-executable instructions, when executed by the processor, cause the controller to further perform the method of: determining at least one of a current rise time, a current draw, or a current settling time with respect to the at least one subsystem.

The non-transitory computer-readable medium of any previous clause, wherein the computer-executable instructions, when executed by the processor, cause the controller to further perform the method of: comparing the at least one of the current rise time, the current draw, or the current settling time to a threshold.

A diagnostic system for a power converter, the diagnostic system comprising: a power supply connected to the power converter via an input line, the power converter configured to receive electrical energy via the input line to power one or more subsystems of the power converter; one or more sensors electrically connected to the input line; and a controller electrically connected to the power converter and the one or more sensors, the controller configured to: monitor, during a start-up sequence of the one or more subsystems, a current flowing through the input line via the sensor during at least a portion of the start-up sequence; and analyze the current to determine a health status of at least one subsystem of the one or more subsystems.

A diagnostic system for a power converter, the diagnostic system comprising: a power supply connected to the power converter via a first input line, the power converter configured to receive electrical energy via the first input line to power one or more subsystems of the power converter; one or more second input lines electrically connected to the first input line and respective ones of the one or more subsystems; one or more sensors electrically connected to the one or more second input lines; and a controller electrically connected to the power converter and the one or more sensors, the controller configured to: monitor, via the one or more sensors, a current flowing through the respective one or more second input lines via the respective one or more sensors; and analyze the current to determine a health status of at least one subsystem of the one or more subsystems.

A diagnostic system for an aeronautical power system, the diagnostic system comprising: a power converter electrically connected to an electrical system of an aircraft; a power supply connected to the power converter via an input line, the power converter configured to receive electrical energy via the input line to power one or more subsystems of the power converter; one or more sensors electrically connected to the input line; and a controller electrically connected to the power converter and the one or more sensors, the controller configured to: monitor, during a start-up sequence of the one or more subsystems, a current flowing through the input line via the one or more sensors during at least a portion of the start-up sequence; analyze the current to determine a health status of at least one subsystem of the one or more subsystems; and in response to identifying a current anomaly affecting the health status of the at least one subsystem, output an indication of the health status.

The diagnostic system of any preceding clause, wherein the one or more subsystems comprise at least one of a fan, a switching module, or a contactor.

The diagnostic system of any preceding clause, wherein the controller is configured to determine at least one of a current rise time, a current draw, or a current settling time with respect to the at least one subsystem.

The diagnostic system of any preceding clause, wherein the controller is configured to compare the at least one of the current rise time, the current draw, or the current settling time to a threshold.

The diagnostic system of any preceding clause, wherein the controller is configured to, after a completion of the start-up sequence, monitor the current during a run mode of the power converter.

The diagnostic system of any preceding clause, wherein the controller is configured to store data corresponding to the current flowing through the input line during the start-up sequence.

The diagnostic system of any preceding clause, wherein the controller is configured to correlate the data to a respective subsystem.

The diagnostic system of any preceding clause, wherein the controller is configured to determine whether the data indicates a trend.

The diagnostic system of any preceding clause, wherein the one or more sensors comprise at least one sensor located remote from the power converter.

The diagnostic system of any preceding clause, wherein the input line comprises a first input line, and wherein the power converter comprises a power bus electrically coupled to the first input line, wherein the power bus is configured to deliver the electrical energy to the one or more subsystems via one or more respective second input lines, and wherein the one or more sensors are electrically coupled to the one or more respective second input lines.

A method for diagnostic analysis of a power converter electrically connected to an electrical system of an aircraft, the method comprising: initiating a start-up sequence of one or more subsystems of the power converter; monitoring, during at least a portion of the start-up sequence, a current flowing through an input line electrically connected to the power converter, wherein the power converter receives electrical energy via the input line to power the one or more subsystems; analyzing the current to determine a health status of at least one subsystem of the one or more subsystems; and, in response to identifying a current anomaly affecting the health status of the at least one subsystem, outputting an indication of the health status.

The method of any preceding clause, further comprising determining at least one of a current rise time, a current draw, or a current settling time with respect to the at least one subsystem.

The method of any preceding clause, further comprising comparing the at least one of the current rise time, the current draw, or the current settling time to a threshold.

The method of any preceding clause, further comprising, after a completion of the start-up sequence, monitoring the current during a run mode of the power converter.

The method of any preceding clause, further comprising storing data corresponding to the current flowing through the input line during the start-up sequence.

The method of any preceding clause, further comprising correlating the data to a respective subsystem.

The method of any preceding clause, further comprising determining whether the data indicates a trend.

A non-transitory computer-readable medium comprising computer-executable instructions, which when executed by a processor associated with a controller, cause the controller to perform a method for diagnostic analysis of a power converter electrically connected to an electrical system of an aircraft, the method comprising: monitoring, during at least a portion of a start-up sequence of one or more subsystems of the power converter, a current flowing through an input line electrically connected to the power converter, wherein the power converter receives electrical energy via the input line to power the one or more subsystems; analyzing the current to determine a health status of at least one subsystem of the one or more subsystems; and, in response to identifying a current anomaly affecting the health status of the at least one subsystem, outputting an indication of the health status.

The non-transitory computer-readable medium of any preceding clause, wherein the computer-executable instructions, when executed by the processor, cause the controller to further perform the method of: determining at least one of a current rise time, a current draw, or a current settling time with respect to the at least one subsystem.

The non-transitory computer-readable medium of any preceding clause, wherein the computer-executable instructions, when executed by the processor, cause the controller to further perform the method of: comparing the at least one of the current rise time, the current draw, or the current settling time to a threshold.

This written description uses examples to disclose the present disclosure, including the best mode, and also to enable any person skilled in the art to practice the disclosure, including making and using any devices or systems and performing any incorporated methods. The patentable scope of the disclosure is defined by the claims, and may include other examples that occur to those skilled in the art. Such other examples are intended to be within the scope of the claims if they include structural elements that do not differ from the literal language of the claims, or if they include equivalent structural elements with insubstantial differences from the literal languages of the claims.

## Claims

1. A diagnostic system for an aeronautical power system, the diagnostic system comprising:
a power converter electrically connected to an electrical system of an aircraft;
a power supply connected to the power converter via an input line, the power converter configured to receive electrical energy via the input line to power one or more subsystems of the power converter;
one or more sensors electrically connected to the input line; and
a controller electrically connected to the power converter and the one or more sensors, the controller configured to:
monitor, during a start-up sequence of the one or more subsystems, a current flowing through the input line via the one or more sensors during at least a portion of the start-up sequence;
analyze the current to determine a health status of at least one subsystem of the one or more subsystems; and
in response to identifying a current anomaly affecting the health status of the at least one subsystem, output an indication of the health status.

2. The diagnostic system of claim 1, wherein the one or more subsystems comprise at least one of a fan, a switching module, or a contactor.

3. The diagnostic system of claim 1 or 2, wherein the controller is configured to determine at least one of a current rise time, a current draw, or a current settling time with respect to the at least one subsystem.

4. The diagnostic system of claim 3, wherein the controller is configured to compare the at least one of the current rise time, the current draw, or the current settling time to a threshold.

5. The diagnostic system of any preceding claim, wherein the controller is configured to, after a completion of the start-up sequence, monitor the current during a run mode of the power converter.

6. The diagnostic system of any preceding claim, wherein the controller is configured to store data corresponding to the current flowing through the input line during the start-up sequence.

7. The diagnostic system of claim 6, wherein the controller is configured to correlate the data to a respective subsystem and/or to determine whether the data indicates a trend.

8. The diagnostic system of any preceding claim, wherein the one or more sensors comprise at least one sensor located remote from the power converter.

9. The diagnostic system of any preceding claim, wherein the input line comprises a first input line, and wherein the power converter comprises a power bus electrically coupled to the first input line, wherein the power bus is configured to deliver the electrical energy to the one or more subsystems via one or more respective second input lines, and wherein the one or more sensors are electrically coupled to the one or more respective second input lines.

10. A method for diagnostic analysis of a power converter electrically connected to an electrical system of an aircraft, the method comprising:
initiating a start-up sequence of one or more subsystems of the power converter;
monitoring, during at least a portion of the start-up sequence, a current flowing through an input line electrically connected to the power converter, wherein the power converter receives electrical energy via the input line to power the one or more subsystems;
analyzing the current to determine a health status of at least one subsystem of the one or more subsystems; and
in response to identifying a current anomaly affecting the health status of the at least one subsystem, outputting an indication of the health status.

11. The method of claim 10, further comprising:
determining at least one of a current rise time, a current draw, or a current settling time with respect to the at least one subsystem; and
optionally, comparing the at least one of the current rise time, the current draw, or the current settling time to a threshold.

12. The method of claim 10 or 11, further comprising, after a completion of the start-up sequence, monitoring the current during a run mode of the power converter.

13. The method of any of claims 10 to 12, further comprising storing data corresponding to the current flowing through the input line during the start-up sequence.

14. A non-transitory computer-readable medium comprising computer-executable instructions, which when executed by a processor associated with a controller, cause the controller to perform a method for diagnostic analysis of a power converter electrically connected to an electrical system of an aircraft, the method comprising:
monitoring, during at least a portion of a start-up sequence of one or more subsystems of the power converter, a current flowing through an input line electrically connected to the power converter, wherein the power converter receives electrical energy via the input line to power the one or more subsystems;
analyzing the current to determine a health status of at least one subsystem of the one or more subsystems; and
in response to identifying a current anomaly affecting the health status of the at least one subsystem, outputting an indication of the health status.

15. The non-transitory computer-readable medium of claim 14, wherein the computer-executable instructions, when executed by the processor, cause the controller to further perform the method of:
determining at least one of a current rise time, a current draw, or a current settling time with respect to the at least one subsystem; and
optionally, comparing the at least one of the current rise time, the current draw, or the current settling time to a threshold.
